(19) Europäisches Patentamt
European Patent Office
Office européen des brevets

(11) Numéro de publication: **0 227 496**
**B1**

(12) **FASCICULE DE BREVET EUROPEEN**

(45) Date de publication du fascicule du brevet:
**19.09.90**

(51) Int. Cl.⁵: **G01R 1/073**

(21) Numéro de dépôt: **86402249.6**

(22) Date de dépôt: **10.10.86**

(54) Appareil de mesure de la résistivité d'une couche mince.

(30) Priorité: **16.10.85 FR 8515335**

(43) Date de publication de la demande:
**01.07.87 Bulletin 87/27**

(45) Mention de la délivrance du brevet:
**19.09.90 Bulletin 90/38**

(84) Etats contractants désignés:
**DE GB IT NL**

(56) Documents cités:
**US-A- 4 204 155**

**IBM TECHNICAL DISCLOSURE BULLETIN,
vol. 25, no. 4, septembre 1982, pages 1847-1848, New
York, US; K.E. BURBANK et al.: "Four-point probe
fixture with single degree of freedom"**

(73) Titulaire: **Thévenot, Louis, 3, Allée de la Piat,
F-38240 Meylan(FR)**
Titulaire: **Hauuy, Jean-Claude, 10, Hameau du Sorbier La
Croix des Ayes, F-38190 Crolles(FR)**
Titulaire: **Salas, Salvador, 3, Rue Gaston Angelier
Cidex 251 B Crolles, F-38190 Brignoud(FR)**

(72) Inventeur: **Thévenot, Louis, 3, Allée de la Piat,
F-38240 Meylan(FR)**
Inventeur: **Hauuy, Jean-Claude, 10, Hameau du Sorbier
La Croix des Ayes, F-38190 Crolles(FR)**
Inventeur: **Salas, Salvador, 3, Rue Gaston Angelier
Cidex 251 B Crolles, F-38190 Brignoud(FR)**

(74) Mandataire: **Mongrédien, André et al, c/o
BREVATOME 25, rue de Ponthieu, F-75008 Paris(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

## Description

La présente invention a pour objet un appareil de mesure de la résistivité d'une couche mince. Elle trouve une application principale dans le test électrique des couches minces entrant dans la fabrication des circuits intégrés.

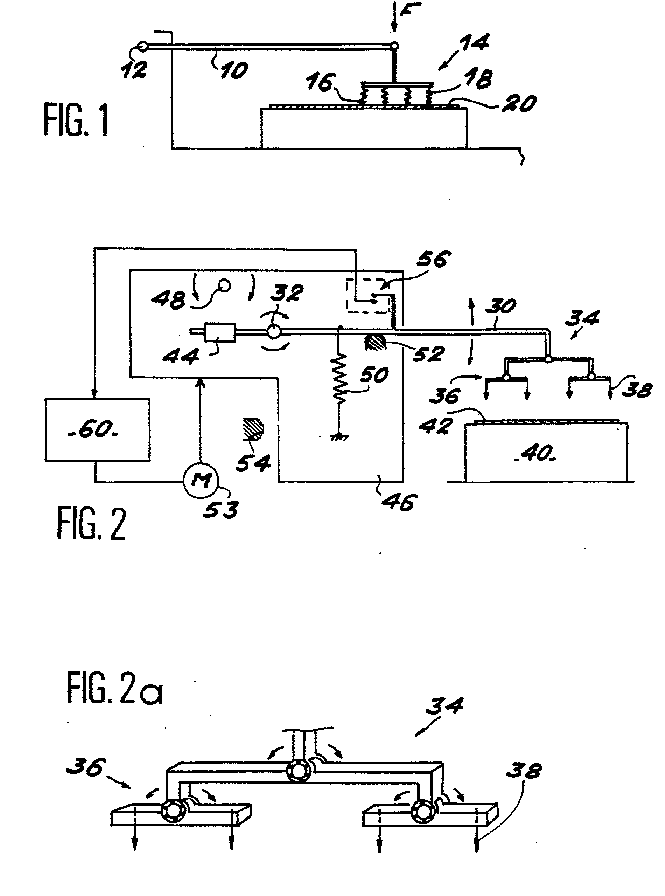

Les appareils actuels de mesure de résistivité des couches minces sont basés sur un principe qui est illustré sur la figure 1. Ces appareils comprennent un bras 10 articulé autour d'un axe horizontal 12 et une tête de mesure 14 comportant quatre pointeaux 16 montés sur des ressorts 18. Les quatre pointeaux sont en contact électrique avec une plaquette 20 à tester. La somme des quatre forces de contact des quatre pointeaux est égale à la force F qui est appliquée à l'extrémité du bras et qui peut être engendrée par un ressort taré.

Les forces de contact des différents pointeaux sont sensiblement les mêmes, mais diffèrent tout de même du fait des incertitudes dimensionnelles du système et du relief de la plaquette à tester. Dans la pratique, les forces de contact appliquées sont supérieures à 5 grammes, parce qu'en dessous de cette valeur, des disparités trop importantes apparaissent entre les forces réelles exercées par chacun des quatre pointeaux.

Or il est reconnu qu'il serait préférable de construire les appareils de mesure de résistivité de couches minces à partir de forces de contact plus faibles, par exemple de 1 à 5g, afin de pouvoir mesurer la résistivité de couches très minces, par exemple de 100 nm d'épaisseur. Dans ce cas, une force de contact trop élevée provoque le perçage de la couche à mesurer, et une disparité ou imprécision de cette force provoque, même sans perçage, des détériorations de la couche et des aberrations dans les mesures.

L'invention remédie à ces inconvénients en proposant un appareil qui assure une précision et une égalité des quatre forces de contact exercées sur la plaquette, même à très faible valeur. L'appareil de l'invention fonctionne correctement entre 1g et 50g.

A cette fin, l'invention prévoit l'utilisation d'un bras articulé dont l'axe de rotation est monté sur une plaque support, elle-même articulée autour d'un second axe de rotation horizontal, un ressort liant le bras à la plaque support de bras. La plaque support de bras peut être mise en rotation par un organe moteur jusqu'à une première butée réglable. La rotation de la plaque support de bras entraîne le bras en rotation jusqu'à ce que les pointeaux de la tête de mesure viennent en appui sur la couche mince à mesurer. La rotation de la plaque support se poursuit jusqu'à la première butée et provoque ainsi, de la part du ressort, une force appliquée au bras, force qui s'exerce sur la couche mince par l'intermédiaire des pointeaux de la tête de mesure.

De préférence, la tête de mesure comprend un palonnier apte à répartir la force qui s'exerce sur le bras de manière égale sur les quatre pointeaux.

De toute façon, les caractéristiques de l'invention apparaîtront mieux à la lecture de la description qui suit, d'un exemple de réalisation donné à titre explicatif et nullement limitatif. Cette description se réfère à des dessins annexés sur lesquels :

- la figure 1, déjà décrite, illustre un appareil de l'art antérieur,
- la figure 2 illustre le principe de l'appareil selon l'invention et la figure 2a un palonnier,
- la figure 3 illustre un mode particulier de réalisation de l'invention.

L'appareil représenté sur la figure 2 comprend un bras de mesure 30 articulé autour d'un axe 32. A une extrémité de ce bras se trouve une tête de mesure 34 formée d'un palonnier 36 et de quatre pointeaux 38. Le palonnier qui est de type classique est représenté plus en détail sur la figure 2a. La tête de mesure fait face à une table 40 qui supporte la couche 42 dont on veut mesurer la résistivité. l'autre extrémité du bras comporte un contrepoids 44. L'appareil comprend encore une plaque support 46 mobile en rotation autour d'un axe horizontal 48. L'axe de rotation 32 du bras est solidaire de cette plaque support. Par ailleurs, le bras est relié à la plaque par un ressort 50. En position de repos, le bras repose sur une butée 52.

La plaque support 46 peut être actionnée en rotation par un moteur 53, jusqu'au contact avec une butée réglable 54. Enfin, l'appareil comprend un contact électrique 56 reliant la plaque support 46 au bras articulé 30. Ce contact est relié à un circuit 60 qui commande le moteur 53.

Le fonctionnement de cet appareil est le suivant. En position de repos, les divers organes sont dans la position illustrée sur la figure 2. Le bras repose sur sa butée 52. Pour mettre l'appareil en position de travail, le moteur 53 fait pivoter la plaque 46 autour de son axe 48. Le bras articulé, qui est monté sur cette plaque, est entraîné lui aussi dans cette rotation. Il arrive un moment où les quatre pointeaux 38 viennent en contact avec la couche mince 42. Dès lors, le bras est immobilisé et quitte la butée 52. La plaque 46 continue cependant à tourner autour de son axe, de sorte que le ressort 50 se bande et vient exercer une traction sur le bras 30. La plaque 46 vient enfin en contact avec la butée 54. La force finalement appliquée au bras correspond à la tension du ressort 50 dans la position où les deux pièces 30 et 36 sont en butée. Par ailleurs, dès que le bras 30 quitte la butée 52, le contact 56 s'ouvre et indique au circuit 60 que les pointeaux sont venus en appui sur la couche 42 et que la mesure de résistivité peut commencer. Celle-ci consiste, de manière classique, à mesurer le rapport d'une tension appliquée, à un courant qui circule à travers la couche.

Naturellement, le schéma de la figure 2 peut conduire à des modes de réalisation différents selon la structure réelle des divers organes représentés, lesquels n'apparaissent, sur cette figure, que de façon schématique et fonctionnelle. C'est ainsi que le ressort 50 n'est pas nécessairement un ressort du type à boudin, mais peut être constitué par une lame élastiqe. L'organe 56 n'est pas nécessairement du type à relais. Il peut s'agir d'un organe optoélectronique par exemple.

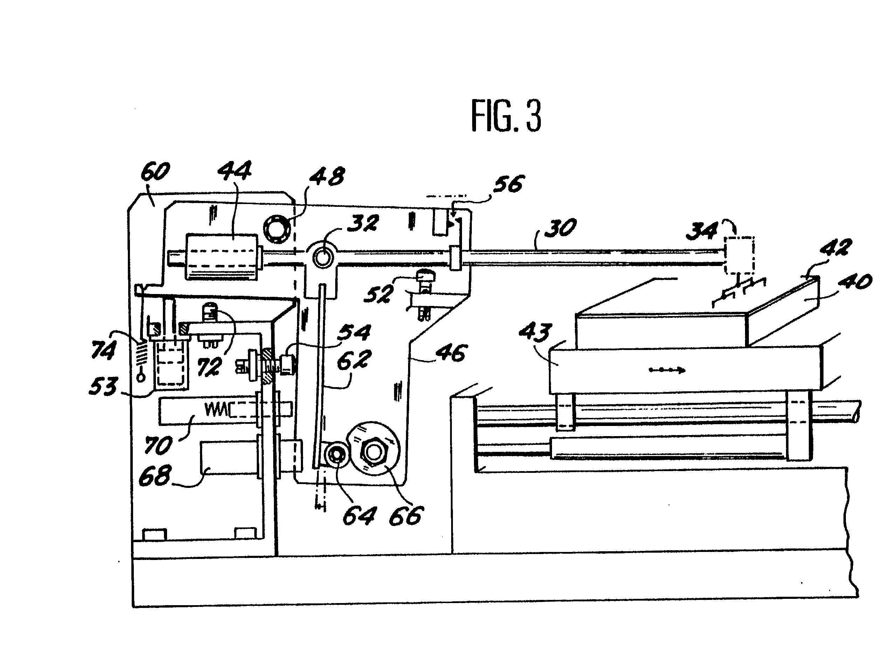

La figure 3 illustre justement un mode particulier de réalisation de l'appareil de l'invention qui correspond à ces variantes. Sur cette figure, on retrouve des éléments dejà représentés sur la figure 2 et qui portent, pour cette raison, les mêmes références. Il s'agit du bras 30, de l'axe 32, de la tête de mesure 4, du contrepoids 44, de la plaque support de bras 46 avec son axe 48, de la butée de bras 52, du moteur 53, de la butée de support de bras 54 et du contact 56. Dans ce mode de réalisation, la plaque support 46 se présente sous la forme d'un T articulé sur l'axe 48, lequel est solidaire d'une équerre support 60. Le ressort exerçant une traction sur le bras 32 est constitué par une lame élastique 62 dont l'extrémité supérieure est solidaire du bras et l'extrémité inférieure munie d'un galet à bille 64 en appui sur une came 66, cette dernière étant solidaire de la plaque support 46. Cet en semble came-galet permet de régler la tension de la lame élastique en position de travail. Un détecteur analogique inductif 68, disposé en regard du galet, permet de mesurer cette tension. Par ailleurs, l'appareil comprend un amortisseur 70 (du genre "dashipot") et une butée de support de bras 72.

Enfin, un ressort de rappel 74 permet de ramener le système à sa position de repos lorsque le vérin est inactif.

L'organe moteur 53 est avantageusement un vérin actionné par une électrovanne commandée par un circuit électronique non représenté.

Les axes de rotation 32 et 48 sont de préférence à roulement à billes pour éviter le jeu et réduire les frottements. Le palonnier peut être également réalisé à l'aide de roulements à billes.

## Revendications

1. Appareil de mesure de la résistivité d'une couche mince (42), cet appareil comprenant un bras (30) articulé autour d'un axe de rotation horizontal (32), ce bras (30) étant muni à une extrémité d'une tête de mesure (34) à plusieurs pointeaux (38) et un moyen pour exercer une force sur ce bras (30) pour appliquer les pointeaux (38) sur la couche (42) à mesurer, cet appareil étant caractérisé par le fait que l'axe de rotation (32) du bras (30) est monté sur une plaque support (46) elle-même articulée autour d'un second axe de rotation horizontal (48), un ressort (50) reliant le bras (30) à la plaque support (46), ladite plaque support de bras (46) pouvant être en rotation par un organe moteur (53) jusqu'à une première butée réglable (54), la rotation de la plaque support de bras (46) entraînant le bras (30) en rotation jusqu'à ce que les pointeaux (38) de la tête de mesure (34) viennent en appui sur la couche mince (42) à mesurer, la rotation de la plaque support (46) se poursuivant jusqu'à la première butée (54) et provoquant ainsi de la part du ressort (50) une force appliquée au bras (30), force qui s'exerce sur la couche mince (42) par l'intermédiaire des pointeaux (38) de la tête de mesure (34).

2. Appareil selon la revendication 1, caractérisé par le fait que la tête de mesure (34) comprend un palonnier (36) apte à répartir la force qui s'exerce sur le bras (30) de manière égale sur les différents pointeaux (38).

3. Appareil selon la revendication 1, caractérisé par le fait qu'en position de repos, le bras (30) repose sur une seconde butée (52) liée à la plaque support (46).

4. Appareil selon la revendication 3, caractérisé par le fait qu'il comprend un contact électrique (56) relié au bras (30) et indiquant si le bras (30) est en appui sur sa seconde butée (52) ou s'il a décollé de cette seconde butée (52).

5. Appareil selon la revendication 1, caractérisé par le fait que le bras articulé (30) comporte un contrepoids (44) à l'extrémité opposée de la tête de mesure (32).

## Claims

1. Apparatus for measuring the resistivity of a thin layer (42), this apparatus including an arm (30) articulated around an axle of horizontal rotation (32), this arm (30) being equipped at one end with a measuring head (34) with several needles (38) and a device for exerting a force on this arm (30) to apply the needles (38) onto the layer (42) to be measured, this apparatus being characterized in that the axle of rotation (32) of the arm (30) is mounted on a support plate (46) itself articulated around a second axle of horizontal rotation (48), a spring (50) linking the arm (30) with the support plate (46), said arm-supporting plate (46) being able to be set in rotation by a motor unit (53) as far as a first adjustable stop (54), the rotation of the arm-supporting plate (46) carrying along the arm (30) in rotation until the needles (38) of the measuring head (34) come to rest on the thin layer (42) to be measured, the rotation of the support plate (46) continuing as far as the first stop (54) and thus causing on the part of the spring (50) a force applied to the arm (30), force which is exerted on the thin layer (42) by means of the needles (38) of the measuring head (34).

2. Apparatus according to Claim 1, characterized in that the measuring head (34) includes a swing-bar (36) capable of distributing the force which is exerted on the arm (30) uniformly over the different needles (38).

3. Apparatus according to Claim 1, characterized in that, in the resting position, the arm (30) rests on a second stop (52) connected to the support plate (46).

4. Apparatus according to Claim 3, characterized in that it includes an electric contact (56) connected to the arm (30) and indicating whether the arm (30) is at rest on its second stop (52) or whether it has come away from this second stop (52).

5. Apparatus according to Claim 1, characterized in that the articulated arm (30) includes a counterweight (44) at the end opposite the measuring head (32).

## Patentansprüche

1. Gerät zum Messen des spezifischen Widerstandes einer dünnen Schicht (42), wobei dieses Gerät einen um eine horizontale Drehachse (32) gelenkig angebrachten Arm (30) umfaßt, wobei dieser Arm (30) mit einem Meßkopfende (34) mit mehreren Spitzen (38) und einer Vorrichtung zum Ausüben einer Kraft auf den Arm (30), um die Spitzen (38) auf die zu messende Schicht (42) zu bringen, versehen ist, wobei das Gerät gekennzeichnet ist durch die Tatsache, daß die Rotationsachse (32) des Arms (30) auf einer Trägerplatte (46) montiert ist, die selbst um eine zweite, horizontale Drehachse (48) gelenkig angebracht ist, wobei eine Feder (50) den Arm (30) mit der Stützplatte (46) verbindet, wobei die Stützplatte (46) des Arms durch einen Motor (53) bis zu einem ersten, einstellbaren Anschlag (54) in Drehrichtung versetzt werden kann, wobei die Drehung der Stützplatte (46) des Arms eine Drehung des Arms (30) nach sich zieht, bis die Spitzen (38) des Meßkopfes (34) auf die zu messende, dünne Schicht (42) kommen, wobei die Drehung der Stützplatte (46) bis zum ersten Anschlag (54) erfolgt und so durch die Feder (50) eine auf den Arm (30) wirkende Kraft erzeugt, die über die Spitzen (38) des Meßkopfs (34) auf die dünne Schicht (42) wirkt.

2. Gerät nach Anspruch 1, gekennzeichnet durch die Tatsache, daß der Meßkopf einen Hebel (36) aufweist, der geeignet ist, die auf den Arm (30) wirkende Kraft gleichmäßig auf die verschiedenen Spitzen (38) zu verteilen.

3. Gerät nach Anspruch 1, gekennzeichnet durch die Tatsache, daß der Arm (30) in der Ruhestellung an einem zweiten, mit der Stützplatte (46) verbundenen Anschlag (52) anliegt.

4. Gerät nach Anspruch 3, gekennzeichnet durch die Tatsache, daß es einen mit dem Arm (30) verbundenen, elektrischen Kontakt (56) aufweist, der anzeigt, ob der Arm am zweiten Anschlag (52) anliegt oder ob er sich von dem zweiten Anschlag (52) gelöst hat.

5. Gerät nach Anspruch 1, gekennzeichnet durch die Tatsache, daß der gelenkig angebrachte Arm (30) an dem dem Meßkopf (32) gegenüberliegenden Ende ein Gegengewicht (44) aufweist.

EP 0 227 496 B1

FIG. 1

FIG. 2

FIG. 2a

# FIG. 3

EP 0 227 496 B1